(19) Europäisches Patentamt
European Patent Office
Office européen des brevets

(11) Veröffentlichungsnummer: **0 674 463 A1**

(12) **EUROPÄISCHE PATENTANMELDUNG**

(21) Anmeldenummer: **94104618.7**

(51) Int. Cl.⁶: **H04R 25/00**, H03G 3/20

(22) Anmeldetag: **23.03.94**

(43) Veröffentlichungstag der Anmeldung:
**27.09.95 Patentblatt 95/39**

(84) Benannte Vertragsstaaten:
**CH DE DK FR LI NL**

(71) Anmelder: **Siemens Audiologische Technik GmbH**
**Gebbertstrasse 125**
**D-91058 Erlangen (DE)**

(72) Erfinder: **Weinfurtner, Oliver, Dipl.-Ing.**
**Wichernstrasse 16**
**D-91052 Erlangen (DE)**

(74) Vertreter: **Fuchs, Franz-Josef, Dr.-Ing. et al**
**Postfach 22 13 17**
**D-80503 München (DE)**

(54) **Programmierbares Hörgerät.**

(57) Das Hörgerät (1) zeichnet sich durch ein verein-fachtes und zugleich optimiertes Regelungssystem dadurch aus, daß im Verstärker- und Übertragungsteil (4) Regelfunktionen vorgesehen sind, die ganz oder teilweise als Fuzzy-Logik-Regler (5) ausgeführt sind.

FIG 1

EP 0 674 463 A1

Rank Xerox (UK) Business Services
(3.10/3.09/3.3.4)

Die Erfindung betrifft ein programmierbares Hörgerät mit einem in seinen Übertragungseigenschaften zwischen Mikrofon und Hörer auf verschiedene Übertragungscharakteristika einstellbaren Verstärker- und Übertragungsteil.

Ein programmierbares Hörgerät in Mehrkanal-Ausführung, bei dem hinter dem die Eingangsschallsignale aufnehmenden Mikrofon eine Anordnung aus mehreren Signalzweigen angeordnet ist, von welchen jeder aus jeweils einem frequenzselektiven Filter, einer pegelabhängigen Verstärkungsregelung und einer Anordnung zur nichtlinearen Signalverformung besteht, gefolgt von einem die Teilsignale zusammenfassenden Summierverstärker, der über einen Endverstärker mit einem Ausgangssignalwandler (Hörer) verbunden ist, ist aus der EP-B-0 071 845 bekannt.

Aus der DE-A-27 16 336 ist ferner ein Hörgerät bekannt, bei dem das analoge, vom Mikrofon kommende Schallsignal nach Durchlaufen eines Tiefpaßfilters in einem A/D-Wandler in ein digitales Signal umgesetzt und einer diskreten Signalverarbeitungsschaltung zugeführt wird, deren Übertragungsfunktion n-ter Ordnung aus in einem elektrisch programmierbaren Festwertspeicher (EPROM) gespeicherten Parametern mittels eines Mikroprozessors mit arithmetischer Einheit zur Anpassung an die Gehörschädigung steuerbar ist. Die Programmierung kann durch Löschen des Festwertspeichers und erneutes Programmieren geändert werden. Das so modifizierte Digitalsignal wird dann in einem D/A-Wandler in ein entsprechendes Analogsignal umgesetzt, verstärkt und dem Hörer zugeführt.

Ferner ist aus der EP-B-0 064 042 eine Schaltungsanordnung für ein Hörgerät bekannt, bei dem in dem Hörgerät selbst in einem Speicher beispielsweise die Parameter mehrerer verschiedener Umgebungssituationen abgespeichert sind. Durch Betätigen eines Schalters wird eine erste Gruppe von Parametern abgerufen und steuert über eine Steuereinheit einen zwischen Mikrofon und Hörer eingeschalteten Signalprozessor, der dann eine erste, für eine vorgesehene Umgebungssituation bestimmte Übertragungsfunktion einstellt. Über einen Schalter können sonach die Übertragungsfunktionen mehrerer gespeicherter Signalübertragungsprogramme nacheinander abgerufen werden, bis die gerade zur gegebenen Umgebungssituation passende Übertragungsfunktion gefunden ist.

Folglich ist es bekannt, Hörgeräte an den individuellen Hörverlust des zu versorgenden Hörgeräteträgers anzupassen. Dabei wird auch eine Einstellung des Hörgerätes für verschiedene Hörsituationen vorgesehen. Programmierbare Hörgeräte bieten eine Vielzahl von einstellbaren Parametern, welche die möglichst optimale Anpassung des elektroakustischen Verhaltens des Hörgerätes an den zu kompensierenden Gehörschaden ermöglichen sollen.

Aufgabe der Erfindung ist es, ein programmierbares Hörgerät zu schaffen, das sich durch ein vereinfachtes und optimiertes Regelungssystem auszeichnet.

Erfindungsgemäß wird diese Aufgabe bei einem programmierbaren Hörgerät der eingangs genannten Art dadurch gelöst, daß im Verstärker- und Übertragungsteil Regelfunktionen vorgesehen sind, die ganz oder teilweise als Fuzzy-Logik-Regler ausgeführt sind.

Mit dem Einsatz eines Fuzzy-Logik-Reglers bei modernen Programmierbaren Hörgeräten werden deren Signalverarbeitungsfunktionen besonders zur Anpassung des Dynamikbereichs des Eingangssignals an den im allgemeinen eingeschränkten Dynamikbereich des Hörgeschädigten verbessert, da sich spezifische Regelungsfunktionen durch Fuzzy-Logik-Komponenten besser realisieren bzw. ergänzen lassen und andererseits ein einfacheres Einstellen der Reglercharakteristik ermöglichen. Des weiteren wird auch ein gezielteres Einbringen von nichtlinearen Anteilen in die Reglercharakteristik möglich.

Vorteilhafte Ausführungsformen der Erfindung sind durch die Patentansprüche 2 bis 18 gekennzeichnet.

Weitere Vorteile und Einzelheiten der Erfindung werden nachfolgend anhand der in den Figuren dargestellten Ausführungsbeispiele näher erläutert.

Es zeigen:

Figur 1 ein Blockschaltbild eines erfindungsgemäßen Hörgerätes,

Figur 2 eine Struktur der Signalaufbereitung und des Reglers für eine Fuzzy-Logik-Regelschaltung für eine dynamische Regelung (AGC) eines Hörgerätes gemäß Figur 1,

Figur 3 eine stromspiegelschaltung, die für die Fuzzyfizierungskomponente des Fuzzy-Logik-Reglers ein Eingangs-Stromsignal und ein Einheits-Stromsignal (Referenzsignal) mehrfach und mit den beiden Flußrichtungen bildet,

Figur 4 eine Schaltung des Fuzzy-Logik-Reglers zur Verarbeitung von Stromsignalen und von Einheits-Stromsignalen zur Bildung der linguistischen Terme,

Figur 5 eine Abbildung einer Eingangsgröße auf einem Teilsegment eines linguistischen Terms, zur Schaltung gemäß Figur 4,

Figur 6 eine weitere Schaltung des Fuzzy-Logik-Reglers zur Verarbeitung von Stromsignalen und von Einheits-Stromsignalen zur Bildung der linguistischen Terme,

Figur 7 eine Abbildung einer Eingangsgröße auf einem Teilsegment eines linguistischen Terms zur Schaltung gemäß Figur 6,

Figuren 8, 9 Stromspiegelschaltungen zur Bildung des Komplements bei einer Negation im Regelwerk, die Gruppen von Schaltungen gemäß den Figuren 4 bzw. 6 nachgeordnet werden,

Figuren 10, 11 Schaltungsanordnungen zur Realisierung der logischen Operationen **AND** und **OR** als Minimum- und Maximum-Bildung,

Figur 12 Darstellungen zur Überlagerung der aktivierten Ausgangsterme und Bildung des Flächenschwerpunktes mit Ableitungen zu Berechnungsformeln,

Figur 13 beispielshafte Darstellungen des Grundprinzips für ein einfaches Fuzzy-Logik-Regelwerk und seine Bearbeitung.

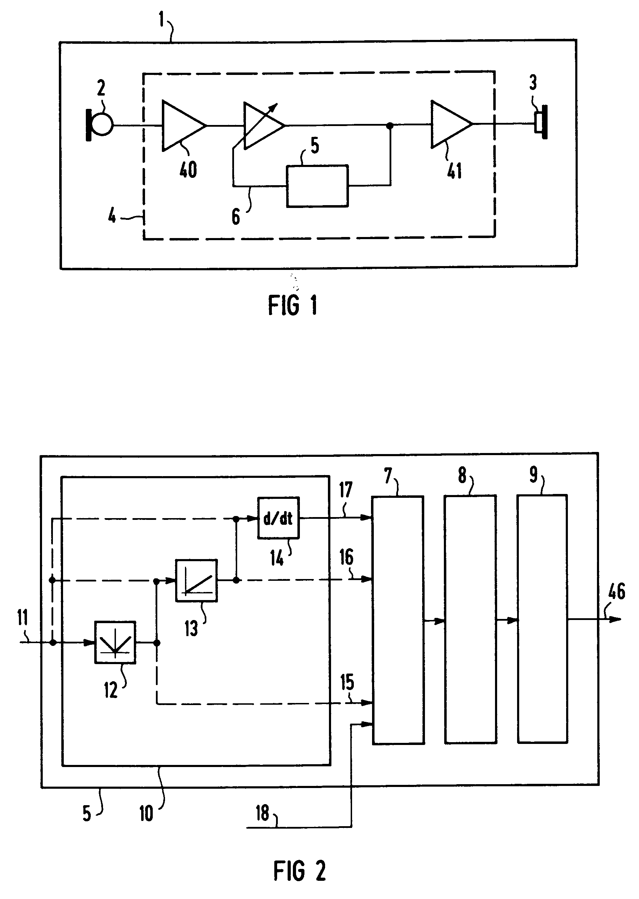

Das in Figur 1 schematisch dargestellte erfindungsgemäße Hörgerät 1 nimmt über ein Mikrofon 2 Schallsignale auf. Diese akustische Information wird im Mikrofon in elektrische Signale umgesetzt und in einem Eingangsverstärker 40 verstärkt. Nach einer Signalbearbeitung in einem Verstärkungs- und Übertragungsteil 4 wird das einen Endverstärker 41 verlassende elektrische Signal einem Hörer 3 als Ausgangswandler zugeführt. Im Ausführungsbeispiel wird im Signalpfad zwischen dem Mikrofon 2 und dem Hörer 3 eine zu regelnde Ausgangsgröße in einer Regelschaltung 6 mit dynamischer Regelung (AGC = Automatic Gain Control) abgegriffen und aufbereitet. Diese Signalaufbereitung und Regelung erfolgt mittels eines Fuzzy-Logik-Reglers 5.

Das Prinzip eines Fuzzy-Logik-Reglers für Signalverarbeitungsfunktionen am Beispiel der AGC (Automatic Gain Control) zeigt Figur 2 anhand der Struktur einer Signalaufbereitung 10 des Fuzzy-Logik-Reglers 5. In der Signalaufbereitung 10 werden aus einer Meßgröße 11 (Eingangssignal) z.B. durch eine Gleichrichtung 12 und/oder eine Mittelwertbildung 13 - Bildung eines zeitlichen Mittelwertes - und/oder eine zeitliche Ableitung 14 (Ableitungsblock d/dt) aus der/den Meßgröße(n) 11 aufbereitete Signale 15-17 gewonnen, die der Fuzzyfizierungskomponente 7 des Fuzzy-Logik-Reglers 5 zugeführt werden. In an sich bekannter Ausführung sind der Fuzzyfizierungskomponente 7 des Fuzzy-Logik-Reglers 5 noch eine Inferenzbildungs-Komponente 8 sowie eine Defuzzyfizierungs-Komponente 9 nachgeordnet.

Das Regelwerk des Fuzzy-Logik-Reglers 5 ist hierbei kein eigenständiger Funktionsblock, sondern als Struktur der Komponenten 7-9 implementiert. Der Regelsatz (if ... then ...

- Beschreibung des Reglerverhaltens) ist also weitgehend unveränderlich in der Hardwarestruktur der Komponenten 7-9 enthalten.

Folgende mögliche Verallgemeinerungen können sich aus der Ausführung nach Figur 2 ergeben:

- Die Bildung des zeitlichen Mittelwerts (sowie eventuell der zugehörigen Ableitung) kann mehrfach mit unterschiedlichen Zeitkonstanten geschehen, um auf verschieden schnelle Änderungen des Signalpegels spezifisch reagieren zu können.
- Gleichermaßen kann auch das Signal direkt, also ohne Bildung eines zeitlichen Mittelwertes, der Fuzzyfizierungskomponente 7 zugeführt werden, um auf Signalspitzen reagieren zu können.
- Weitere Signale 18, wie Systeminformationssignale über die momentan eingestellte Hörsituation oder eine am Hörgerät eingestellte Mikrofon-/Telefonspulenposition oder zur Kennzeichnung des Batteriezustandes des Hörgerätes, können der Fuzzyfizierungskomponente 7 zugeführt werden, um diese Signale 18 ebenfalls in das Reglerverhalten mit einbeziehen zu können.
- Sowohl mehrere Eingangsgrößen/Meßgrößen 11 als auch Ausgangsgrößen 46 sind möglich, so daß das Signal an unterschiedlichen Stellen des gesamten Signalpfades in die Regelung mit einbezogen werden kann bzw. die Regelung an mehreren Stellen im Signalpfad eingreifen kann.

Die Erfindung ist nicht auf die Zuordnung eines Fuzzy-Logik-Reglers 5 für eine Regelschaltung 6 mit dynamischer Regelung (AGC) beschränkt. Ohne gesonderte Darstellung von Ausführungsbeispielen ist es möglich, daß das Verstärker- und Übertragungsteil 4 des Hörgerätes 1 eine an sich bekannte Begrenzerschaltung (PC = Peak Clipping) aufweist und daß dieser Begrenzerschaltung erfindungsgemäß ein Fuzzy-Logik-Regler zugeordnet ist. Nach einer weiteren Ausbildung kann das Verstärker- und Übertragungsteil eine automatische Lautstärkeregelung aufweisen, der ein Fuzzy-Logik-Regler zugeordnet ist. Bei einem programmierbaren Hörgerät in Mehrkanal-Ausführung ist es möglich, daß in den einzelnen Frequenzkanälen einstellbare Verstärker- und Übertragungsteile vorgesehen und diesen Verstärker- und Übertragungsteilen Fuzzy-Logik-Regler zugeordnet sind.

In den folgenden schaltungstechnischen Ausführungen erfolgt die Realisierung der erforderlichen Fuzzy-Logik-Komponenten insbesondere in analoger Schaltungstechnik. Fuzzy-Logik-Operationen können als Algorithmen nachgebildet werden, welche auf digitalen Rechen- und Operationswerken ablaufen. Insbesondere wegen des bei Hörgeräten begrenzten kleinen Einbauraums für die Schaltungsbauteile ist bei der heute möglichen Technik die rein digitale Schaltung nicht ohne weiteres ausführbar, da die für die digitale Schaltungstechnik erforderliche Fläche auf einem integrierten Schaltkreis für Hörgeräte in der Regel nicht zur Verfügung steht. Außerdem wäre die benötigte Leistungsaufnahme für ein Hörgerät zu groß, da das digitale Operationswerk mit hoher Taktfrequenz arbeiten müßte, um alle notwendigen Operationen in Echtzeit zu realisieren. Die Regelung der analogen Signalverarbeitung durch einen digital realisierten Regler würde ferner zu einer starken Störung der analogen Signale durch die digitalen Schaltelemente führen.

Aus diesen Gründen beschreibt die Erfindung die Realisierung der Fuzzy-Logik-Operationen in analoger Schaltungstechnik. Dabei sind die auftretenden Signale als Ströme realisiert. Zur Umsetzung von Spannungs- in Stromsignale und umgekehrt sind allgemein bekannte Schaltungen verwendbar.

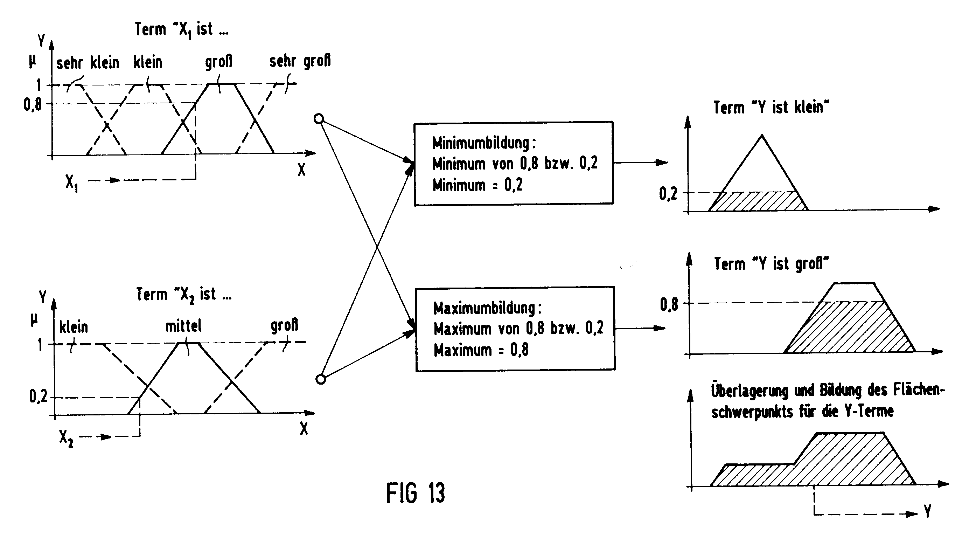

Figur 13 zeigt ein einfaches Fuzzy-Logik-Regelwerk und seine prinzipielle Bearbeitung. Ein erster Schritt für die Implementierung einer Fuzzy-Logik-Struktur ist die Definition der linguistischen Variablen für ihre Eingangs- und Ausgangsgrößen. Für jede dieser Größen werden deren Terme über einer numerischen Werteskala aufgetragen. Über den x-Achsen der gezeichneten Koordinatenkreuze sind variable Größen dargestellt, wobei der Wert $\mu$ in der y-Achse den Erfüllungs- oder Wahrheitsgrad der jeweiligen Aussage angibt.

Aus dem in Figur 13 gezeichneten Beispiel ergibt sich folgender Regelsatz:

1. if $x_1$ ist groß **and** $x_2$ ist mittel **then** y ist klein
2. if $x_1$ ist groß **or** $x_2$ ist mittel **then** y ist groß

Für eine schaltungstechnische Umsetzung dieses beispielhaften Fuzzy-Logik-Regelwerks sind folgende Teilfunktionen zu realisieren:

- Fuzzyfizierung: Abbildung der Eingangswerte auf die linguistischen Variablen, d.h. Ermittlung der Werte der Zugehörigkeitsfunktionen einer jeden Eingangsgröße zu den einzelnen Termen der relevanten linguistischen Variablen. Hierbei kann eventuell auch die Bildung des Komplements des ermittelten Wertes notwendig sein.
- Ermittlung von Minima (als Realisierung des logischen AND) und Maxima (als Realisierung des logischen OR) der miteinander verknüpften aktivierten linguistischen Variablen.
- Überlagerung der aktivierten Ausgangsterme und Bildung des Flächenschwerpunktes.

Speziell für die dargestellte analoge schaltungstechnische Realisierung der Fuzzy-Logik-Operationen ist vor der eigentlichen Verarbeitung eine Aufbereitung des Eingangssignals und auch eines benötigten Einheitssignals/Referenzsignals nötig. Da mit Strom- und nicht mit Spannungssignalen gearbeitet wird, müssen diese vor ihrer Weiterverarbeitung genügend oft dupliziert werden. Außerdem werden sie für die weitere Verarbeitung zum Teil in positiver, zum Teil in negativer Flußrichtung benötigt.

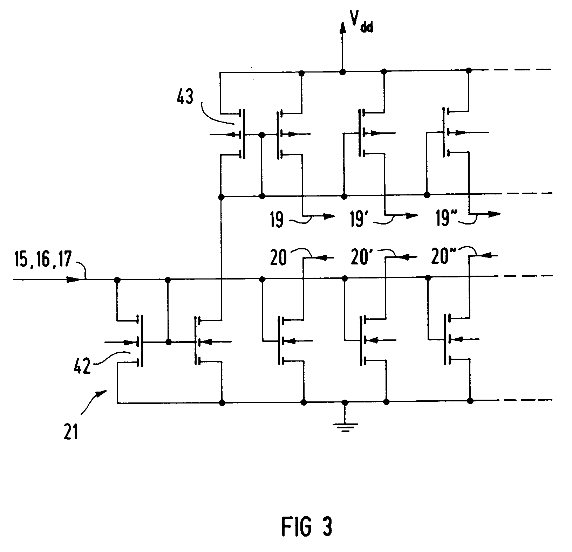

Sowohl das Duplizieren als auch die Richtungsumkehr erfolgt mittels Stromspiegelschaltungen 21 gemäß Figur 3. Die Stromspiegelschaltung 21 ist unter Verwendung von N-MOS-Transistoren 42 und P-MOS-Transistoren 43 aufgebaut. Nach der Erfindung wird jedes der der Fuzzyfizierung 7 zugeführte Signal 15, 16, 17 einem Stromspiegel 21 zugeführt und in mehrere gleich große Stromsignale von gleicher Stromrichtung 19, 19', 19'' sowie von entgegengesetzter Stromrichtung 20, 20', 20'' umgesetzt. Vdd gibt in der Zeichnung den Schaltungsanschluß zur Versorgungsspannung an, wobei die Stromspiegelschaltung 21 an sich bekannt ist.

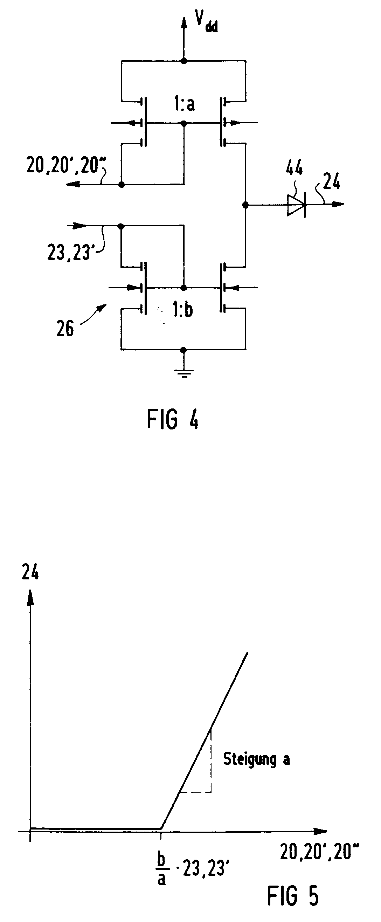

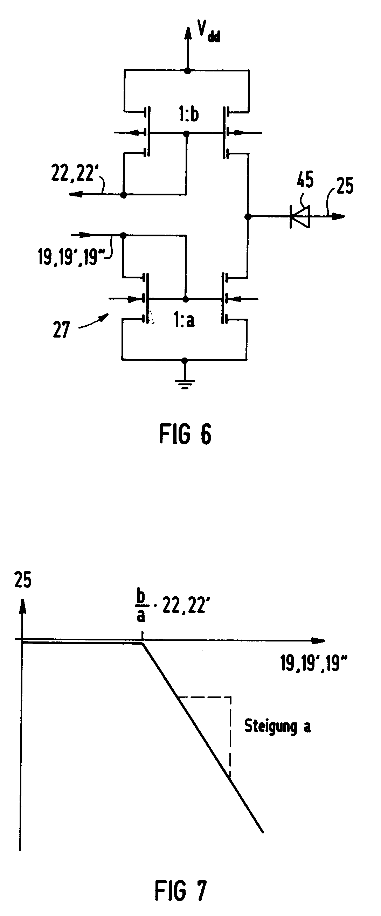

Die Fuzzyfizierung (Ermittlung der Zugehörigkeitsgrade des Eingangssignals zu den einzelnen Termen der linguistischen Variablen) erfolgt mittels der beiden in den Figuren 4 und 6 dargestellten Schaltungen 26 bzw. 27. Jede der beiden Schaltungen 26, 27 realisiert dabei ein Teilsegment der Zugehörigkeitsfunktion.

Funktionsweise der Schaltungen 26, 27:

Den Transistorschaltungen 26, 27 werden Einheitsstromsignale 22, 22' bzw. 23, 23' zugeführt. Dabei ist ein vorgegebenes Einheitsstromsignal/Referenzsignal über einen Stromspiegel der genannten Art in entsprechende Einheitsstromsignale 22, 22' bzw. 23, 23' duplizierbar. Der Einheitsstromwert dieser Referenz-Stromsignale entspricht dem maximalen Wert 1 der Stromsignale 19, 19', 19'' bzw. 20, 20', 20''. Durch eine entsprechende Dimensionierung der Stromspiegel 26, 27 (Auslegung der Transistorgrößenverhältnisse) wird erreicht, daß die zugeführten Stromsignale 19, 19', 19'' bzw. 20, 20', 20'' im Verhältnis 1:a von der Eingangsseite auf die Ausgangsseite gespiegelt werden und die Einheits-Stromsignale 22, 22' bzw. 23, 23' im Verhältnis 1:b. Durch die Sperrwirkung der Dioden 44 bzw. 45 in einer Richtung ergeben sich die in den Figuren 5 bzw. 7 dargestellten Stromübertragungsverhältnisse. Die Größen a und b stellen die Transistorgrößenverhältnisse in den Schaltungen 26, 27 dar. Gleichzeitig erscheinen die Größen a und b in den zu den Schaltungen 26, 27 gehörenden Kennlinien gemäß den Figuren 5 bzw. 7. Danach sind die Stromausgangswerte 24, 25 der Schaltungen 26 bzw. 27 so lange gleich Null, bis der Stromwert der zugeführten Stromsignale 19, 19', 19'' bzw. 20, 20', 20'' den Wert

$$\frac{b}{a} \bullet (22, \ 22')$$

bzw. den Wert

$$\frac{b}{a} \bullet (23, \quad 23')$$

überschreitet. Dann wachsen die Stromausgangswerte 24, 25 linear mit der Steigung a an bzw. fallen linear mit der Steigung a ab. Die Auslegung der Transistorgrößenverhältnisse a bzw. b der mit N-MOS- und P-MOS-Transistoren aufgebauten Transistorschaltungen bestimmt den Kurvenverlauf der Stromausgangswerte 24, 25. Durch eine Überlagerung der von den Schaltungen 26 und 27 gebildeten Teilsegmente (was einer Parallelschaltung der jeweiligen entsprechend dimensionierten Schaltungsteile entspricht) läßt sich jede gewünschte Zugehörigkeitsfunktion aus Geradenstücken approximieren. Je gröber die Approximation ist, d.h. je weniger Geradenstücke verwendet werden, desto geringer ist der Schaltungsaufwand.

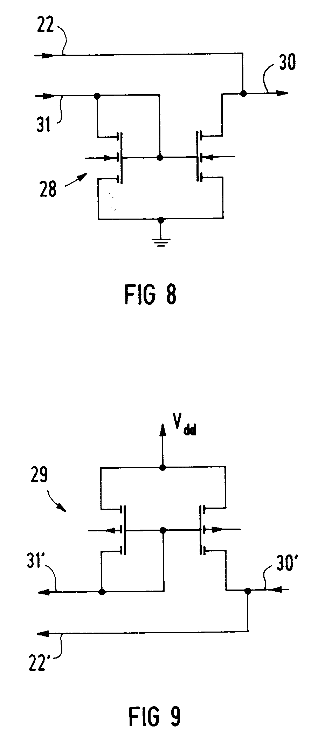

Erfordert eine Negation im Regelwerk die Bildung eines Komplements von einem oder von mehreren Zugehörigkeitswerten, so kann dies dadurch erfolgen, daß den oben beschriebenen Schaltungsgruppen eine der Schaltungen gemäß den Figuren 8, 9 nachgeordnet wird. Gemäß den Figuren 8, 9 ergibt sich der Stromausgangswert 30 bzw. 30' der stromspiegelschaltung 28 bzw. 29 aus der Differenz zwischen dem Einheits- oder Referenzstrom 22, 22' und einem Eingangs-Stromsignal 31, 31'. Beispielsweise ergibt sich der Stromausgangswert 30 aus dem Einheitsstrom/Referenzstrom 22 abzüglich des Stromwertes des Eingangs-Stromsignales 31, wobei der Einheitsstrom 22 den Wert 1 besitzt und das Eingangs-Stromsignal 31 einen Wert zwischen Null und 1 hat.

Inferenzbildung:

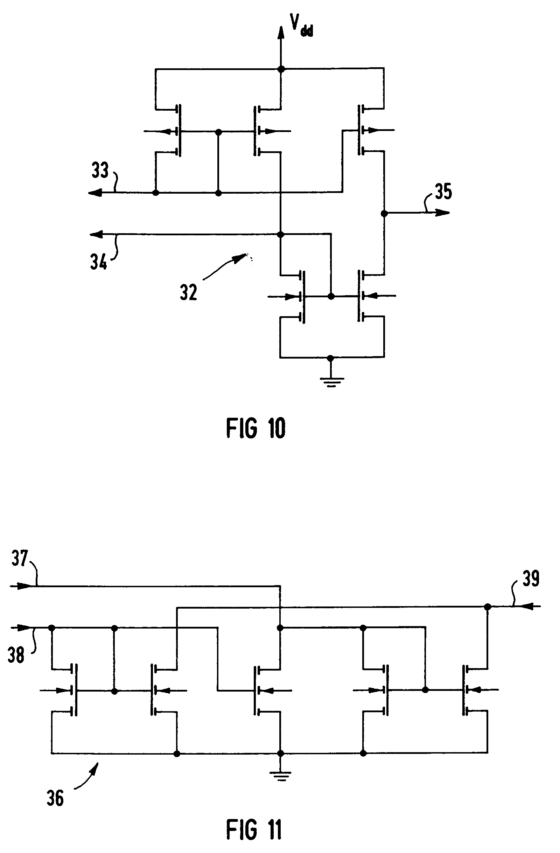

Werden die beiden logischen Operationen AND und OR, wie meist üblich, als Minimum- und Maximum-Bildung realisiert, dann sind hierfür die beiden Schaltungen 32, 36 nach Figur 10 und 11 einsetzbar. Die Stromausgangssignale 35 bzw. 39 der Schaltung 32 nach Figur 10 bzw. der Schaltung 36 nach Figur 11 stellen jeweils das Minimum (Figur 10) bzw. das Maximum (Figur 11) der beiden Stromeingangssignale 33, 34 bzw. 37, 38 dar. Sind mehr als zwei Eingangsgrößen zu verarbeiten, dann können die betreffenden Schaltungen entsprechend kaskadiert eingesetzt werden.

Defuzzyfizierung (Überlagerung der aktivierten Ausgangsterme und Bildung des Flächenschwerpunktes):

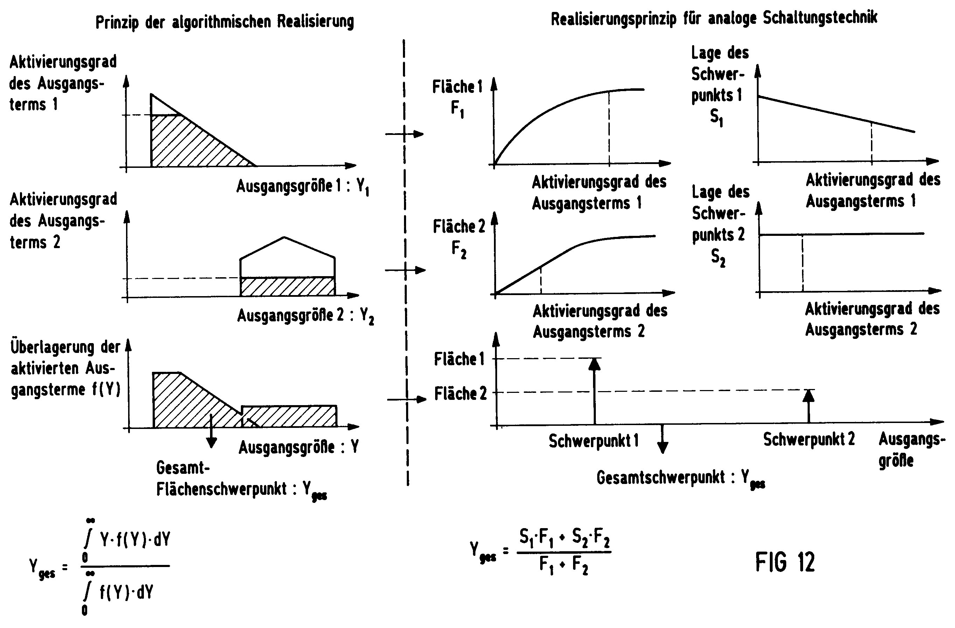

Diese Operation kann in digital realisierten Fuzzy-Logik-Systemen mit Hilfe eines Algorithmus implementiert werden. Für die Umsetzung in analoger Technik ist dagegen der Übergang zu einer anderen formellen Darstellung dieser Operationsschritte notwendig, wie in Figur 12 gezeigt wird. Die Aktivierung eines Ausgangsterms liefert eigentlich zwei Werte, nämlich die aktivierte Fläche des Ausgangsterms und den zugehörigen Flächenschwerpunkt. Beide Größen lassen sich deshalb auch getrennt darstellen, nämlich als zwei getrennte Funktionen einer gemeinsamen Variablen. Schaltungstechnisch realisieren lassen sie sich dann prinzipiell genauso wie die oben erläuterten Zugehörigkeitsfunktionen. Die Überlagerung der aktivierten Ausgangsterme und die Bildung ihres gemeinsamen Schwerpunktes (defuzzifizierter Ausgangswert) geschieht nun durch die in Figur 12 angegebene Rechenoperation nach der Formel

$$Y_{ges} = \frac{\sum_{n=1}^{N} S_n \cdot F_n}{\sum_{n=1}^{N} F_n}$$

dabei ist

$Y_{ges}$ = scharfer Ausgangswert (Gesamtschwerpunkt)

$S_n$ = Schwerpunktslage des n-ten aktivierten Ausgangsterms

$F_n$ = Fläche des n-ten aktivierten Ausgangsterms

$N$ = Anzahl aller Ausgangsterme.

Hiernach werden zwei Werte gebildet. Der erste Wert ergibt sich aus der Summe aller aktivierten Flächen und multipliziert mit dem jeweils zugehörigen Schwerpunkt der aktivierten Fläche. Der zweite Wert ist die Summe aller aktivierten Flächen. Wird der erste Wert durch den zweiten Wert dividiert, ergibt sich der zu ermittelnde Ausgangswert. Die Operationen für die Multiplikation und Division lassen sich durch geläufige Schaltungen der Analogtechnik realisieren. Die Additionen der Ströme erfolgen in den Schaltungsknoten.

Im Gesamtsignalpfad des Fuzzy-Logik-Reglers kann an manchen Schnittstellen zwischen den hier dargestellten Schaltungsblöcken die Umkehr der Flußrichtung der Stromsignale erforderlich sein. Dies wird dann durch Einsatz herkömmlicher Stromspiegel realisiert.

Die auf dem Prinzip der Fuzzy-Logik aufgebaute erfindungsgemäße Regelfunktion im Verstärker- und Übertragungsteil eines programmierbaren Hörgerätes zeichnet sich insbesondere durch folgende Vorteile aus:

Es bestehen verbesserte Möglichkeiten beim Einstellen der gewünschten Regelcharakteristik von Funktionsblöcken, wie AGC, PC, automatische Lautstärkeregelung des Hörgerätes, u.a. durch Einbringen von nichtlinearen Anteilen. Auf einfache und genau definierbare Weise können unterschiedliche Eingangsgrößen in die Regelcharakteristik einbezogen werden.

**Patentansprüche**

1. Programmierbares Hörgerät (1) mit einem in seinen Übertragungseigenschaften zwischen Mikrofon (2) und Hörer (3) auf verschiedene Übertragungscharakteristika einstellbaren Verstärker- und Übertragungsteil (4), **dadurch gekennzeichnet,** daß im Verstärker- und Übertragungsteil (4) Regelfunktionen vorgesehen sind, die ganz oder teilweise als Fuzzy-Logik-Regler (5) ausgeführt sind.

2. Hörgerät nach Anspruch 1, **dadurch gekennzeichnet,** daß das Verstärker- und Übertragungsteil (4) eine Regelschaltung (6) mit dynamischer Regelung (AGC) aufweist, der ein Fuzzy-Logik-Regler (5) zugeordnet ist.

3. Hörgerät nach Anspruch 1, **dadurch gekennzeichnet,** daß das Verstärker- und Übertragungsteil eine Begrenzerschaltung (PC, Peak-Clipping) aufweist, der ein Fuzzy-Logik-Regler zugeordnet ist.

4. Hörgerät nach Anspruch 1, **dadurch gekennzeichnet,** daß das Verstärker- und Übertragungsteil eine automatische Lautstärkeregelung aufweist, der ein Fuzzy-Logik-Regler zugeordnet ist.

5. Hörgerät nach den Ansprüchen 1 bis 4, **dadurch gekennzeichnet,** daß bei einem Mehrkanal-Hörgerät in den einzelnen Frequenzkanälen einstellbare Verstärker- und Übertragungsteile vorgesehen und diesen Fuzzy-Logik-Regler zugeordnet sind.

6. Hörgerät nach den Ansprüchen 1 bis 5, **dadurch gekennzeichnet,** daß der Fuzzy-Logik-Regler (5) Komponenten zur Fuzzyfizierung (7), Inferenzbildung (8) und Defuzzyfizierung (9) sowie zur Signalaufbereitung (10) aufweist, wobei der Signalaufbereitung Meßgrößen (11) aus dem Signalpfad zwischen Mikrofon (2) und Hörer (3) zugeführt und diese Meßgrößen (11) in der Signalaufbereitung (10) durch Gleichrichtung (12) und/oder Mittelwertbildung (13) und/oder zeitliche Ableitung (14) bearbeitet und wobei die aus den Meßgrößen (11) aufbereiteten Signale (15, 16, 17) der Fuzzyfizierung (7) zugeführt werden.

7. Hörgerät nach den Ansprüchen 1 bis 6, **dadurch gekennzeichnet,** daß das Regelverhalten des Fuzzy-Logik-Reglers (5) von einem Regelwerk bestimmt ist, wobei dieses Regelwerk in der Struktur der Komponenten zur Fuzzyfizierung (7), Inferenzbildung (8) und Defuzzyfizierung (9) implementiert ist.

8. Hörgerät nach einem der Ansprüche 1 bis 7, **dadurch gekennzeichnet,** daß Signale (18) zur Kennzeichnung der Betriebsart des Hörgerätes (z.B. Telefonspulenbetrieb), zur Kennzeichnung des Einschaltzustandes des Hörgerätes (z.B. gewähltes Programm zum Betrieb des Hörgerätes in lauter oder leiser Umgebungssituation), zur Kennzeichnung des Batteriezustandes od.dgl. direkt der Fuzzyfizierung (7) des Fuzzy-Logik-Reglers (5) zuführbar sind.

9. Hörgerät nach den Ansprüchen 1 bis 8, **dadurch gekennzeichnet,** daß die Fuzzyfizierungskomponente (7) des Fuzzy-Logik-Reglers (5) in analoger Schaltungstechnik ausgeführt ist.

10. Hörgerät nach Anspruch 9, **dadurch gekennzeichnet,** daß jedes der Fuzzyfizierung (7) zugeführte Signal (15, 16, 17) einem Stromspiegel (21) zugeführt und in mehrere gleich große Stromsignale von gleicher Stromrichtung (19, 19', 19'') sowie von entgegengesetzter Stromrichtung (20, 20', 20'') umgesetzt wird (Figur 3).

11. Hörgerät nach den Ansprüchen 9 und 10, **dadurch gekennzeichnet,** daß ein vorgegebenes Einheitssignal (Referenzsignal) über einen gleichartigen Stromspiegel in entsprechende mehrfache Einheits-Stromsignale (22, 22'; 23, 23') umgesetzt wird.

12. Hörgerät nach den Ansprüchen 9 bis 11, **dadurch gekennzeichnet,** daß zur Bildung der linguistischen Terme des Fuzzy-Logik-Reglers (5) die Stromsignale (19, 19', 19'' bzw. 20, 20', 20'') und die Einheits-Stromsignale (22, 22'; 23, 23') in Schaltungen (26, 27) zu Stromausgangswerten (24, 25) verarbeitet und wobei diese Stromausgangswerte zur Termenbildung überlagert werden (Figuren 4 bis 7).

13. Hörgerät nach Anspruch 7 und 12, **dadurch gekennzeichnet,** daß bei einer Negation im Regelwerk der Schaltungsanordnung nach Anspruch 12 Stromspiegelschaltungen (28, 29) nachgeordnet sind, die zur Komplementbildung der linguistischen Terme führen (Figuren 8, 9).

14. Hörgerät nach den Ansprüchen 1 bis 8, **dadurch gekennzeichnet,** daß die Inferenzbildungskomponente (8) des Fuzzy-Logik-Reglers (5) in analoger Schaltungstechnik ausgeführt ist.

15. Hörgerät nach Anspruch 14, **dadurch gekennzeichnet,** daß die "and"- und "or"-Funktionen der Inferenzbildungskomponente (8) durch "Minimum-" und "Maximum-Bildung" der zu verknüpfenden Signale ausgeführt sind.

16. Hörgerät nach Anspruch 14 und 15, **dadurch gekennzeichnet,** daß für die Funktion der Inferenzbildungskomponente (8) zur "Minimum-Bildung" einer Schaltung (32) Stromeingangssignale (33, 34) aus der Fuzzyfizierungskomponente (7) zugeführt und in der Schaltung (32) zu einem das "Minimum" darstellenden Stromausgangssignal (35) verarbeitet werden (Figur 10).

17. Hörgerät nach Anspruch 14 und 15, **dadurch gekennzeichnet,** daß für die Funktion der Inferenzbildungskomponente (8) zur "Maximum-Bildung" einer Schaltung (36) Stromeingangssignale (37, 38) aus der Fuzzyfizierungskomponente (7) zugeführt und in der Schaltung (36) zu einem das "Maximum" darstellenden Stromausgangssignal (39) verarbeitet werden (Figur 11).

18. Hörgerät nach Anspruch 9 und 14, **dadurch gekennzeichnet,** daß in analoger Schaltungstechnik in der Defuzzyfizierungskomponente (9) die Bildung der "scharfen" Ausgangswerte nach

$$Y_{ges} = \frac{\sum_{n=1}^{N} S_n \cdot F_n}{\sum_{n=1}^{N} F_n}$$

erfolgt,
dabei ist

$Y_{ges}$ = scharfer Ausgangswert (Gesamtschwerpunkt)

$S_n$ = Schwerpunktslage des n-ten aktivierten Ausgangsterms

$F_n$ = Fläche des n-ten aktivierten Ausgangsterms

$N$ = Anzahl aller Ausgangsterme

FIG 1

FIG 2

FIG 3

$V_{dd}$

1:a

20,20',20"

44 24

23,23'

26 1:b

FIG 4

24

Steigung a

$\frac{b}{a} \cdot 23,23'$ 20,20',20"

FIG 5

**FIG 6**

**FIG 7**

FIG 8

FIG 9

FIG 10

FIG 11

Prinzip der algorithmischen Realisierung

Realisierungsprinzip für analoge Schaltungstechnik

Aktivierungsgrad des Ausgangsterms 1

Ausgangsgröße 1 : $Y_1$

Aktivierungsgrad des Ausgangsterms 2

Ausgangsgröße 2 : $Y_2$

Überlagerung der aktivierten Ausgangsterme $f(Y)$

Ausgangsgröße : Y

Gesamt-Flächenschwerpunkt : $Y_{ges}$

$$Y_{ges} = \frac{\int_0^\infty Y \cdot f(Y) \cdot dY}{\int_0^\infty f(Y) \cdot dY}$$

Fläche 1 $F_1$

Aktivierungsgrad des Ausgangsterms 1

Fläche 2 $F_2$

Aktivierungsgrad des Ausgangsterms 2

Lage des Schwerpunkts 1 $S_1$

Aktivierungsgrad des Ausgangsterms 1

Lage des Schwerpunkts 2 $S_2$

Aktivierungsgrad des Ausgangsterms 2

Fläche 1
Fläche 2

Schwerpunkt 1    Schwerpunkt 2    Ausgangsgröße

Gesamtschwerpunkt : $Y_{ges}$

$$Y_{ges} = \frac{S_1 \cdot F_1 + S_2 \cdot F_2}{F_1 + F_2}$$

FIG 12

EP 0 674 463 A1

**FIG 13**

EP 0 674 463 A1

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| Y,D | EP-A-0 064 042 (MANGOLD ET AL.) <br> * Seite 4, Zeile 15 - Seite 6, Zeile 24; Abbildungen 1,2 * <br> --- | 1 | H04R25/00 <br> H03G3/20 |
| Y | EP-A-0 398 536 (PIONEER ELECTRONIC CORPORATION) <br> * Seite 2, Spalte 1, Zeile 9 - Spalte 2, Zeile 43; Abbildung 1 * <br> * Seite 5, Spalte 8, Zeile 6 - Zeile 57; Abbildungen 9A,9B,10 * | 1 | |
| A | --- | 6,7 | |
| A | PATENT ABSTRACTS OF JAPAN <br> vol. 015, no. 029 (E-1026) 23. Januar 1991 <br> & JP-A-02 272 814 (OMRON TATEISI ELECTRON CO) <br> * Zusammenfassung * <br> --- | 1,2 | |
| A,D | EP-A-0 071 845 (SIEMENS AG) <br> * Seite 8, Zeile 15 - Seite 9, Zeile 27; Abbildung * <br> --- | 1-4 | **RECHERCHIERTE SACHGEBIETE (Int.Cl.6)** |
| A | US-A-4 716 540 (YAMAKAWA) <br> * Spalte 4, Zeile 19 - Spalte 13, Zeile 34; Abbildungen * <br> --- | 6,9-17 | H04R <br> H03K <br> G06G <br> H03G |
| A | US-A-5 292 995 (USA) <br> * Spalte 6, Zeile 49 - Spalte 10, Zeile 33; Abbildungen 2A,2B,2C,2D * <br> ----- | 15-18 | |

Der vorliegende Recherchenbericht wurde für alle Patentansprüche erstellt

| Recherchenort | Abschlußdatum der Recherche | Prüfer |
|---|---|---|
| DEN HAAG | 2. September 1994 | Gastaldi, G |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

 

& : Mitglied der gleichen Patentfamilie, übereinstimmendes Dokument

EPO FORM 1503 03.82 (P04C03)